# EUROPÄISCHE PATENTSCHRIFT

(11) **EP 2 307 308 B1**
(45) Veröffentlichungstag und Bekanntmachung des Hinweises auf die Patenterteilung: **07.10.2015**
(21) Anmeldenummer: 09779953.0
(22) Anmeldetag: 25.06.2009
(51) Int. Cl.: B81C 1/00

(54) **VERFAHREN ZUM VERKAPPEN EINES MEMS-WAFERS**
METHOD FOR CAPPING A MEMS WAFER
PROCÉDÉ D'ENCAPSULATION D'UNE TRANCHE POUR MICROSYSTÈME

(30) Priorität: 30.07.2008 DE 102008040851
(43) Veröffentlichungstag der Anmeldung: 13.04.2011
(73) Patentinhaber: Robert Bosch GmbH, 70442 Stuttgart (DE)
(72) Erfinder: RUDHARD, Joachim, 70771 Leinfelden-Echterdingen (DE); MUELLER, Thorsten, 71672 Marbach (DE)
(86) Internationale Anmeldenummer: PCT/EP2009/057989
(87) Internationale Veröffentlichungsnummer: WO 2010/012547

(56) Entgegenhaltungen:
- US-A1- 2005 124 089

## Beschreibung

Die vorliegende Erfindung betrifft ein Verfahren zum Verkappen eines MEMS-Wafers, insbesondere eines Sensor- und/oder Aktor-Wafers mit mindestens einem beweglichen mechanischen Funktionselement.

Die US 2005/124089 A1 offenbart ein Verfahren zum Verkappen eines MEMS-Wafers mit mindestens einem mechanischen Funktionselement, wobei eine Kappenschicht über dem unbeweglichen mechanischen Funktionselement abgeschieden wird, die Kappenschicht perforiert wird, anschließend das mechanische Funktionselement beweglich gemacht wird und schließlich die Kappenschicht verschlossen wird.

Sensoren in Siliziumtechnologie werden heute in unterschiedlichsten Prozessen gefertigt. Eine bei der Anmelderin erfolgreich eingesetzte Technologie ist die sogenannte Oberflächenmikromechanik. Nach der Prozessierung werden die fragilen und empfindlichen mechanischen Funktionselemente durch eine Verkappung auf Waferlevelebene vor Umwelteinflüssen geschützt. Dabei ist eine erfolgreich eingesetzte Technologie das Verkappen mit einem zweiten separaten Wafer, der über eine Seal-Glasverbindung an dem Sensor-Wafer festgelegt wird. Nachteilig bei der bekannten Verkappungstechnologie unter Einsatz eines Verkappungs-Wafers ist, dass ein aus zwei Wafern bestehendes System vergleichsweise hoch baut. Darüber hinaus müssen laterale Vorhalte auf dem Sensor-Wafer vorgesehen werden um die Seal-Glasverbindung zwischen Sensor-Wafer und Kappen-Wafer realisieren zu können, was den Flächenbedarf des Wafer-Sensors erhöht

### Offenbarung der Erfindung

### Technische Aufgabe

Der Erfindung liegt die Aufgabe zugrunde, ein alternatives, verbessertes Verkappungsverfahren für MEMS-Wafer vorzuschlagen. Vorzugsweise soll das Verfahrensendprodukt vergleichsweise niedrig bauen und einen vergleichsweise geringen Flächenbedarf aufweisen.

### Technische Lösung

Diese Aufgabe wird hinsichtlich des Verkappungsverfahrens mit den Merkmalen des Anspruchs 1.

Der Erfindung liegt der Gedanke zugrunde, die Verkappung auf MEMS-Waferlevelebene durch eine Kombination eines Opferschichtprozesses mit einem Kappenschicht-Prozess zu realisieren, wobei die Kappenschicht entweder unmittelbar auf die Opferschicht oder auf mindestens eine auf die Opferschicht aufgebrachte Zwischenschicht aufgebracht, insbesondere epitaktisch aufgewachsen, wird. Im Falle der Realisierung einer epitaktisch aufgewachsenen Kappenschicht ist es bevorzugt, entweder unmittelbar auf die Opferschicht oder auf eine auf der Opferschicht vorgesehene Zwischenschicht eine Startschicht, vorzugsweise aus polykristallinem Silizium, aufzubringen, die als Basis für die, vorzugsweise aus Silizium gebildete, Kappenschicht dient Dabei dient die später wieder zu entfernende Opferschicht zur zeitweisen mechanischen Fixierung des beweglichen, fragilen, mindestens einen mechanischen Funktionselementes vor dem Aufbringen, vorzugsweise Aufwachsen der Kappenschicht Anders ausgedrückt wird das zunächst bewegliche mechanische Funktionselement mittels der Opferschicht vorübergehend vor dem Aufbringen der Kappenschicht fixiert, wobei die mit der Opferschicht ausgefüllten Bereiche nach Entfernen der Opferschicht Hohlräume bilden, innerhalb derer sich die Funktionselemente bewegen können. Ein nach dem Konzept der Erfindung ausgebildetes Verfahren zum Verkappen eines MEMS-Wafers ermöglicht es, einen, insbesondere bis auf die Metallisierung, fertig prozessierten MEMS-Wafer vor der Verkappung, also vor dem Aufbringen der Opferschicht und der Kappenschicht zu prüfen, soweit hierfür keine Metallisierung notwendig ist. Eine vollständige Prüfung vor der Verkappung ist möglich, wenn ein Test-Wafer mit Metallisierung prozessiert wird. Ein wesentlicher Vorteil des mit dem vorgeschlagenen Verfahren verkappten MEMS-Wafers ist neben der Prüfbarkeit vor der Verkappung der geringere Raumbedarf, sowohl in Hochrichtung als auch im Bezug auf seine Flächenerstreckung. Dies ist zum einen darauf zurückzuführen, dass die Kombination-aus Opferschicht und Kappenschicht weniger hoch baut als ein separater Verkappungs-Wafer. Zum anderen resultiert die geringere Flächenerstreckung daraus, dass keine lateralen Vorhalte für eine Seal-Glasverbindung oder einen eutektischen Bondrahmen vorgesehen werden müssen, da die Verkappung unmittelbar mit dem MEMS-Wafer verbunden wird.

In Weiterbildung der Erfindung ist mit Vorteil vorgesehen, dass der MEMS-Wafer vor dem Aufbringen der Opferschicht und der Kappenschicht metallisierungsfrei ist. Die Metallisierung wird vorzugsweise, wie später noch erläutert werden wird, nach dem Aufbringen der Kappenschicht, unmittelbar auf die Kappschicht und/oder auf eine auf der Kappenschicht vorgesehene Verschlussschicht aufgebracht. Bei dieser späteren Metallisierung ist das Metall derart anzuordnen, dass, insbesondere über die, vorzugsweise elektrisch leitende, Kappenschicht gewünschte Bereiche des MEMS-Wafers, wie die Substratebene und/oder eine sogenannte beispielsweise aus Polysilizium ausgebildete Verdrahtungsebene kontaktiert werden.

Ganz besonders bevorzugt ist eine Ausführungsform des Verfahrens, bei der das mindestens eine bewegliche mechanische Funktionselement vor dem Verkappungsprozess, also vor dem Aufbringen der Opferschicht auf Funktionsfähigkeit geprüft wird. Mögliche Fehler können somit bereits vor dem Verkappen des MEMS-Wafers erkannt werden.

In Weiterbildung der Erfindung ist mit Vorteil vorgesehen, dass auf den, insbesondere fertigprozessierten MEMS-Wafer eine als Silizium-Germanium-Schicht ausgebildete Opferschicht aufgebracht wird. Besonders geeignet ist hierfür der Einsatz eines LPCVD- oder auch eines PECVD-Verfahrens. Der Germaniumanteil ist dabei einstellbar und kann dem jeweiligen Prozess entsprechend zwischen wenigen und 100 Atom-Prozent liegen. Ganz besonders bevorzugt ist es, wenn die Opferschicht, beispielsweise mittels CMP oder einem ähnlichen Planarisierungsprozess, zur Minimierung der Rauigkeit und Topographie planarisiert (geglättet) wird.

In Weiterbildung der Erfindung ist mit Vorteil vorgesehen, dass die, vorzugsweise epitaktisch gewachsene, Kappenschicht aus Silizium ausgebildet wird, wobei auch alternative, insbesondere aufwachsbare, Substanzen einsetzbar sind. Dabei kann die Kappenschicht, insbesondere in Abhängigkeit des Untergrunds, aus mono- und/oder polykristallinem Silizium gebildet werden. Als Startschicht kann optional eine polykristalline Siliziumschicht eingesetzt werden.

Ganz besonders bevorzugt ist eine Ausführungsform, bei der die Kappenschicht bzw. die Startschicht der Kappenschicht nicht unmittelbar auf die Opferschicht, sondern auf eine bereits erwähnte Zwischenschicht aufgebracht wird. Ganz besonders bevorzugt handelt es sich bei der mindestens einen Zwischenschicht um eine Diffusionsbarriere, die bevorzugt derart ausgebildet ist, dass sie eine unbeabsichtigte Interdiffusion von Silizium und Germanium zwischen der Startschicht, der Kappenschicht und der Opferschicht verhindert. Dabei ist eine Ausführungsform von ganz besonderem Vorteil, bei der diese Diffusionsbarriere, also die mindestens eine Zwischenschicht als HTO-Schicht (High-Temperature-Oxide-Schicht) verwendet wird.

In Weiterbildung der Erfindung ist mit Vorteil vorgesehen, dass die Opferchicht vor dem Aufbringen bzw. Aufwachsen der Kappenschicht strukturiert wird, vorzugsweise derart, dass mindestens ein später elektrisch zu kontaktierender Bereich des MEMS-Wafers freigelegt wird. Anders ausgedrückt wird die Zwischenschicht in Teilbereichen entfernt, sodass die vorzugsweise aus Silizium bestehende Kappenschicht unmittelbaren Kontakt zu mindestens einer elektrisch leitenden Schicht des MEMS-Wafers hat

In Weiterbildung der Erfindung ist mit Vorteil vorgesehen, dass die Kappenschicht, vorzugsweise mittels CMP oder einem ähnlichen Prozess planarisiert wird.

Ganz besonders bevorzugt ist es, wenn die Kappenschicht, vorzugsweise nach dem Planarisieren strukturiert wird, beispielsweise mit dem sogenannten DRIE-Prozess der Anmelderin. Dabei erfolgt die Strukturierung bevorzugt derart, dass ein Zugang zur Opferschicht getrencht wird, um die Opferschicht anschließend, wie später noch erläutert werden wird, insbesondere mit einem ClF₃-Gasfasenätzprozess zu entfernen.

Wie zuvor erwähnt, erfolgt die Strukturierung der Kappenschicht vorzugsweise derart, dass die Opferschicht in mindestens einem Teilbereich freigelegt wird, um die Opferschicht zugänglich zu machen für einen Opferschicht-Entfernungsprozess, vorzugsweise unter Einsatz von ClF₃. Durch die hohe Selektivität zu reinem Silizium ist ein Angriff des mindestens einen mechanischen, frei beweglichen Funktionselementes (Funktionsstruktur) auch ohne Schutzschicht nicht zu erwarten.

Bevorzugt wird in Weiterbildung des Verfahrens nach dem Opferschicht-Entfemungsschritt eine Antihaftschicht (Antistiction-Schicht/ASC-Schicht), beispielsweise mittels eines SIC-Abscheideprozesses aufgebracht, die die Funktionselementstrukturen gegen eine Klebeneigung schützt. Dieser Prozess kann optional gleichzeitig zum Verschließen und Druckeinschluss des mindestens einen Funktionselementes genutzt werden.

Wie erwähnt, kann die Antihaftschicht als Verschlussschicht eingesetzt werden. Die Verschlussschicht hat dabei die Aufgabe, die in die Kappenschicht eingebrachten Strukturen, insbesondere zum Freilegen der dann zu entfernenden Opferschicht am Schluss wieder zu verschließen, sodass das mindestens eine Funktionselement (Funktionsstrukturen) vollständig verkapselt wird.

Die Druckeinstellung in mindestens einer durch das Entfernen der Opferschicht gebildeten, vorzugsweise das mindestens eine Funktionselement aufnehmenden, Kavität kann durch die Einstellung des Systemdrucks während des Aufbringens der Verschlussschicht realisiert werden. Alternativ kann die Druckeinstellung über ein nachfolgendes Gas-Diffusionsverfahren erfolgen.

In Weiterbildung der Erfindung ist mit Vorteil vorgesehen, dass auf die, vorzugsweise zuvor strukturierte, Verschlussschicht und/oder auf die Kappenschicht mindestens eine Metallisierung aufgebracht wird, wobei die Metallisierung, vorzugsweise über die Kappenschicht elektrisch leitend mit entsprechenden Anschlussbereichen des MEMS-Wafers elektrisch leitend verbunden ist. Bevorzugt wird die Metallisierungsschicht strukturiert aufgebracht oder separat strukturiert. Die Metallisierung dient bevorzugt zur elektrischen Anbindung von Kontaktstempeln.

Weiter bevorzugt ist eine Ausführungsform, bei der die in der Verkappung durch Entfernen einer Opferschicht ausgebildeten Kavitäten mit einer Diffusionsbarriereschicht, insbesondere einer HTO-Schicht ausgekleidet sind, wobei auch eine Ausführungsform realisierbar ist, bei der diese zunächst fakultativ vorgesehene Diffusionsbarriereschicht wieder entfernt wurde.

### Kurze Beschreibung der Zeichnungen

Weitere Vorteile, Merkmale und Einzelheiten der Erfindung ergeben sich aus der nachfolgenden Beschreibung eines bevorzugten Ausführungsbeispiels eines Verfahrens zum Verkapseln eines MEMS-Wafers sowie anhand der Zeichnungen. Diese zeigen in:

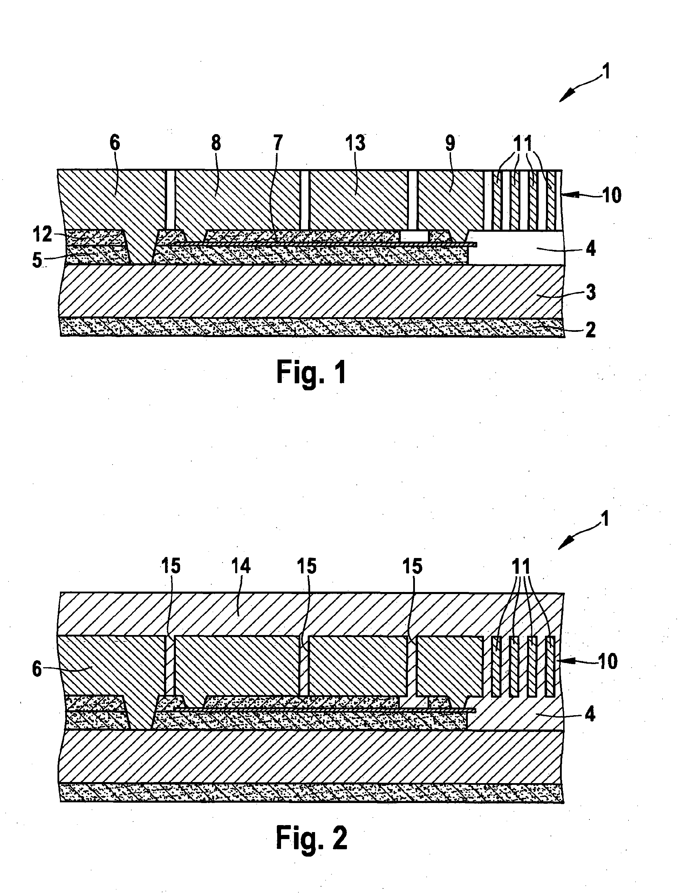

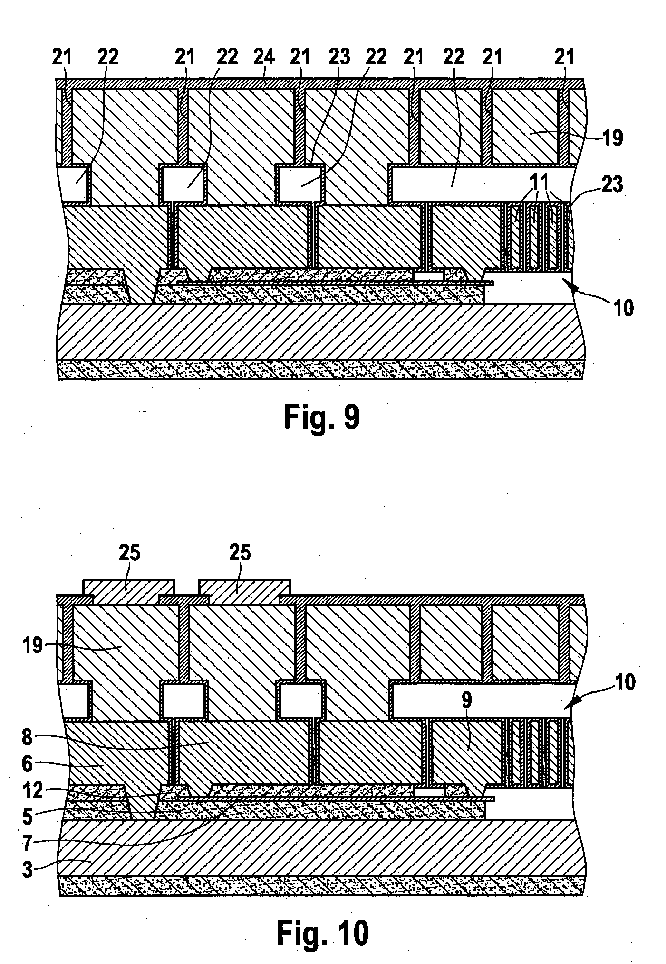

- Fig. 1 bis Fig. 10: zeitlich aufeinander folgende Herstellungsschritte bei der Verkapselung eines MEMS-Wafers, wobei in Fig. 10 ein fertig verkapselter MEMS-Wafer gezeigt ist.

### Ausführungsformen der Erfindung

In den Figuren sind gleiche Bauelemente und Elemente mit der gleichen Funktion mit dem gleichen Bezugszeichen gekennzeichnet.

In Fig. 1 ist als Basis des im Folgenden zu beschreibenden Verkappungsverfahrens ein bis auf eine (Alu-)Metallisierung fertig prozessierter MEMS-Wafer 1 gezeigt. Der lediglich schematisch dargestellte MEMS-Wafer 1 umfasst eine in der Zeichnungsebene untere Trägerschicht 2 aus thermischem Oxid. In der Zeichnungsebene oberhalb der Trägerschicht 2 befindet sich unmittelbar auf-der Trägerschicht 2 eine Substratschicht 3 aus Silizium. Auf der von der Trägerschicht 2 abgewandten Seite der Substratschicht 3 grenzt an diese in der Zeichnungsebene rechts eine Kavität 4 an. Links neben der Kavität 4 ist eine strukturierte Oxidschicht 5 vorgesehen. Die Oxidschicht 5 wird in einem in der Zeichnungsebene linken Bereich-durchsetzt von einer epitaktischen Siliziumschicht 6, um die Substratschicht 3 später kontaktieren zu können. Unmittelbar an die Oxidschicht 5 grenzt eine sogenannte Verdrahtungsebene 7 (Kontaktierungszwischenschicht) an, die einen ersten Bereich 8 der epitaktischen Siliziumschicht 6 elektrisch leitend mit einem zweiten Bereich 9 der Siliziumschicht 6 verbindet, wo bei der zweite Bereich 9 der Siliziumschicht 6 lateral unmittelbar an ein frei bewegliches, mechanisches Funktionselement 10 (Funktionsstruktur) angrenzt. Unterhalb des Funktionselementes 10 sowie zwischen Strukturelementen 11 des Funktionselementes 10 befindet sich ein von der Kavität 4 gebildeter Hohlraum.

Unmittelbar an die Verdrahtungsebene 7 aus Polysilizium schließt eine weitere Oxidschicht 12 an, die die Verdrahtungsebene 7 in der Zeichnungsebene nach oben gegenüber einem weiteren Bereich 13 der epitaktischen Siliziumschicht 6 elektrisch isoliert. Die Bereiche 8 und 9 der epitaktischen Siliziumschicht 6 durchsetzen diese (obere) Oxidschicht 12 und kontaktieren die elektrisch leitende Verdrahtungsebene 7.

Wie sich aus Fig. 1 ergibt, ist der MEMS-Wafer 1 in Form eines Sensors bis auf eine Metallisierung voll prozessiert. Bevorzugt wurde der MEMS-Wafer in der sogenannten Opferschichttechnologie hergestellt. Zu erkennen ist, dass das Funktionselement 10 bzw. die Strukturelemente 11 des Funktionselementes 10 frei sind. Alle Funktionen mit Einschränkung der fehlenden Metallisierung sind in diesem Stadium vor dem Beginn des Verkappungsverfahrens prüfbar.

In Fig. 2 ist ein erster Schritt des Verkappungsverfahrens gezeigt. Hierbei wird auf den in Fig. 1 gezeigten, fertig prozessierten MEMS-Wafer 1 eine Opferschicht 14 aus Silizium-Germanium abgeschieden und fakultativ, beispielsweise mittels eines CMP-Prozesses, planarisiert. Zu erkennen ist, dass sich die Opferschicht 14 in Trenchkanäle 15 der strukturierten epitaktischen Siliziumschicht 6 sowie in die Kavität 4 hinein erstreckt und somit das Funktionselement 10 bzw. die Strukturelemente 11 blockiertdiese sind also nicht mehr frei. Ferner bildet die Opferschicht 14 abschnittsweise in diesem Verfahrensstadium eine oberste Schicht.

Fakultativ kann vor dem Aufbringen der Opferschicht eine Diffusionsbarriere, beispielsweise aus HTO abgeschieden werden, durch die bei hohen Temperaturen eine Diffusion in die Siliziumschicht 6 verhindert wird. Zusätzlich oder alternativ kann ein hochtemperaturfestes Antistiction-Coating aufgebracht werden, das weiter bevorzugt gleichzeitig als Diffusionsbarriere dient.

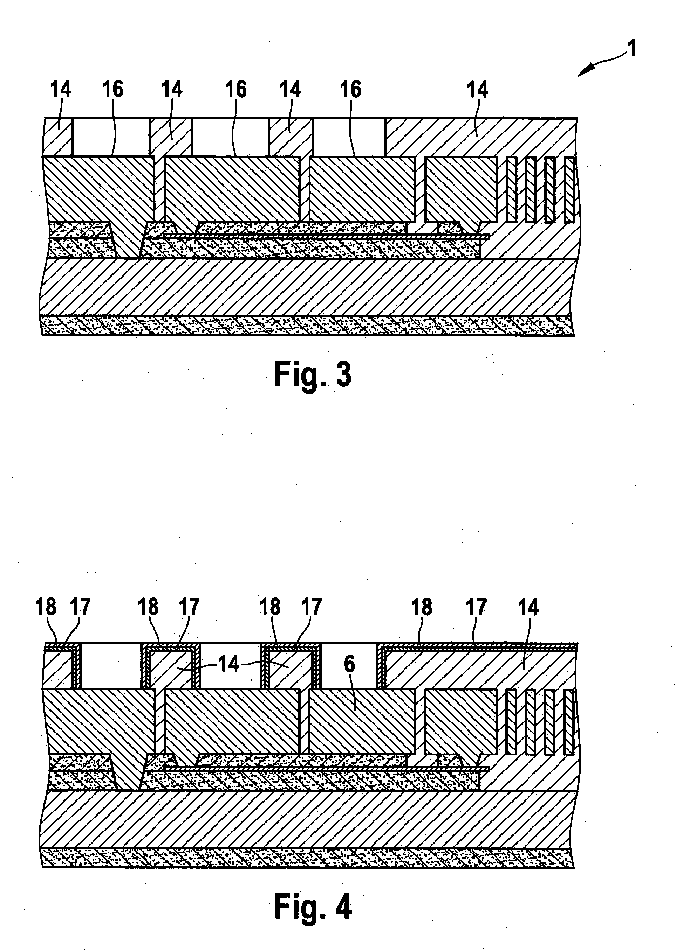

Nach einem weiteren Verkappungsschritt wird das in Fig. 3 gezeigte Ergebnis erhalten. Die Opferschicht 14 ist strukturiert, sodass im Justagebereich Justagemarken 16 für ein späteres Ausrichten (Alignment) freigelegt wurden. Weiterhin dienen die freigelegten Bereiche zur späteren elektrischen Anbindung des MEMS-Wafers 1, in dem eine später noch zu erläuternde Kappenschicht unmittelbaren Kontakt zur epitaktischen Siliziumschicht 6 in den strukturierten Bereichen bekommt.

Als nächster fakultativer Verkappungsschritt, dessen Ergebnis in Fig. 4 gezeigt ist, wird eine als HTO-Diffusionsbarriere ausgebildete Zwischenschicht 17 aufgebracht und strukturiert, derart, dass die Zwischenschicht 17 sich nur auf bzw. an der Opferschicht 14 und nicht auf der epitaktischen Siliziumschicht 6 befindet.

Nach Abscheiden der HTO-Diffusionsbarriere-Zwischenschicht 17 wird in dem gezeigten Ausführungsbeispiel eine LPCVD-Startpoly-Silizium (Startschicht 18) abgeschieden, und vorzugsweise gemeinsam mit der Zwischenschicht 17 strukturiert, sodass sich die Startschicht 18 ausschließlich auf der Zwischenschicht 17 befindet oder im Falle des Verzichts auf eine Zwischenschicht 17 ausschließlich unmittelbar auf der Opferschicht 14. Bevorzugt werden bei der Strukturierung Strukturen von > 30µm entfernt.

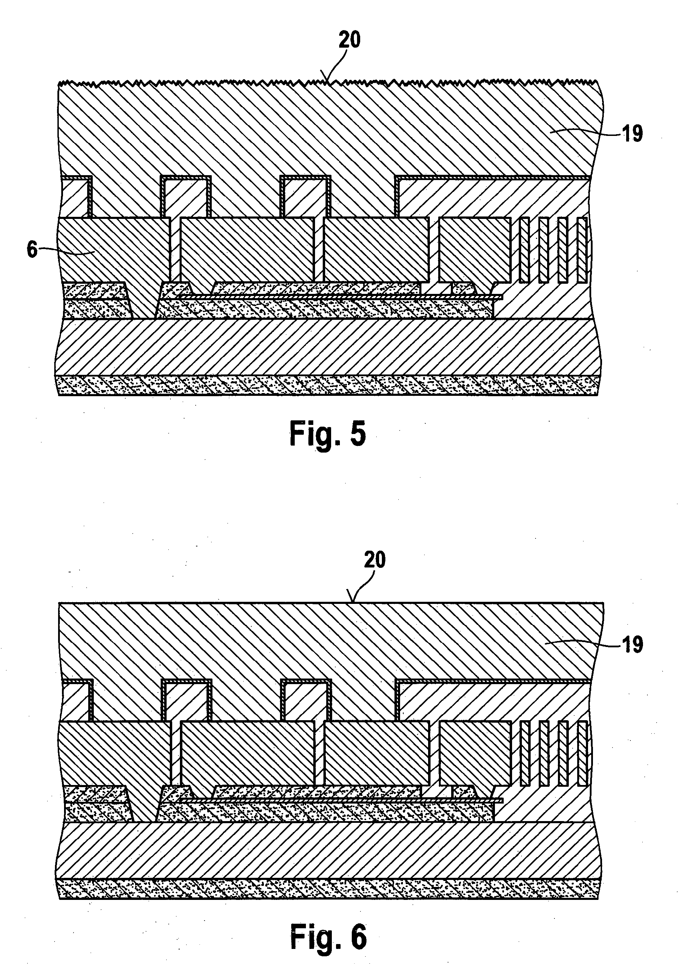

Auf die Startschicht 18 wird in einem darauffolgenden Verfahrensschritt eine Kappenschicht 19 aus Silizium aufgewachsen. Das Ergebnis ist in Fig. 5 gezeigt. Zu erkennen ist, dass die Kappenschicht 19 in dem strukturierten Bereichen der Zwischenschicht 17 und der Opferschicht 14 unmittelbaren Kontakt zur epitaktischen Siliziumschicht 6 hat, also elektrisch leitend mit dieser verbunden ist. Dabei wächst die Kappenschicht 19 aus Silizium in der Zeichnungsebene oberhalb der Zwischenschicht 17 polykristallin und oberhalb, d.h. im Kontaktbereich zur epitaktischen Siliziumschicht 6 monokristallin.

In einem darauffolgenden Schritt wird die Oberfläche 20 der Kappenschicht, beispielsweise mittels eines CMP-Verfahrens planarisiert. Das Ergebnis dieses Verfahrensschritts ist in Fig. 6 gezeigt.

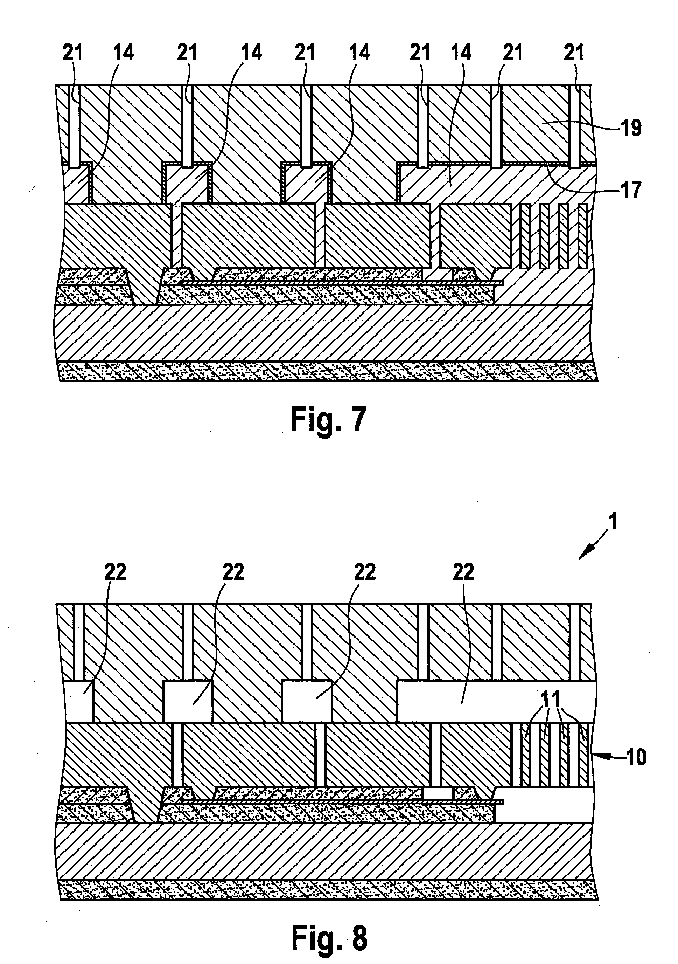

Daraufhin folgt eine Strukturierung der Kappenschicht 19 durch Trenchen. Es ergeben sich die in Fig. 7 gezeigten Release-Strukturen 21 (Trenchkanäle) mit denen die Opferschicht 14 bereichsweise freigelegt, d.h. in der Zeichnung von in der Zeichnungsebene oben zugänglich gemacht wird. Zu erkennen ist, dass in der Zeichnungsebene rechts in einem großen Opferschichtabschnitt mehrere Release-Strukturen 21 vorgesehen sind.

Als nächster Verfahrensschritt erfolgt die Entfernung der Opferschicht 14 also ein sogenannter Silizium-Germanium-Release mit ClF₃, welches eine hohe Selektivität gegenüber Silizium hat und daher ausschließlich die Opferschicht 14 entfernt, wodurch eine Vielzahl von noch nicht verschlossenen Kavitäten 22 gebildet werden, insbesondere auch um das Funktionselement 10 bzw. die Strukturelemente 11 herum, sodass diese sich wieder frei bewegen können.

Wie sich aus Fig. 8 ergibt, wird die auf der Opferschicht 14 vorgesehene Zwischenschicht 17 (Diffusionsbarriere) ebenfalls entfernt, im vorliegenden Ausführungsbeispiel durch den Einsatz von HF in der Gasfase. Alternativ ist es auch möglich, die HTO-Diffusionsbarriere-Zwischenschicht 17 zu belassen.

Als nächster Verfahrensschritt erfolgt das Abscheiden (ASC-Abscheidung) einer Antihaftschicht 23, die die Kavitäten 22 auskleidet und auch die Strukturelemente 11 des Funktionselementes 10 belegt. Die Antihaftschicht 23 kann dabei in einer solchen Menge aufgetragen werden, dass sie gleichzeitig als Verschlussschicht 24 dient, die die Kappenschicht 19 bedeckt und die Release-Strukturen 21 verschließt und damit die Kavitäten 22 abdichtet. Alternativ kann eine von der Antihaftschicht 23 separate Verschlussschicht 24 vorgesehen werden, die zum Verschließen der Release-Struktur 21 und damit zum Abdichten der Kavitäten 22 bzw. zum hermetischen Abkapseln der Strukturelemente 11 des Funktionselementes 10 dient.

Die separate Verschlussschicht 24 kann beispielsweise aus Polysilizium gebildet werden.

Die Druckeinstellung des Gasdrucks in den Kavitäten 22 kann entweder durch Einstellung des Umgebungsdrucks bei der Verschlussschicht-Aufbringung eingestellt werden. Alternativ kann in einem späteren Schritt bei hohen Temperaturen eine Gasdiffusion in die Kavitäten 22 hinein realisiert werden.

In einem weiteren Verfahrensschritt wird die eine Deckschicht bildende Verschlussschicht 24 strukturiert, derart, dass die gewachsene Kappenschicht 19 (Epitaxieschicht) freigelegt wird, um in einem anschließenden Metallisierungsschritt Metallisierungen 25 aufbringen zu können, die die Kappenschicht 19 elektrisch leitend kontaktieren. Die in der Zeichnungsebene linke Metallisierung 25 dient zur elektrischen Kontaktierung der Substratschicht 3 über die Kappenschicht 19 und die epitaktische Siliziumschicht 6, die die Oxidschichten 5, 12 durchsetzt. Die in der Zeichnungsebene rechte Metallisierung 25 dient zur elektrischen Kontaktierung der sogenannten Verdrahtungsebene 7 und damit zur elektrischen Kontaktierung des Bereichs 9 der epitaktischen Siliziumschicht 6, die unmittelbar benachbart zum Funktionselement 10 angeordnet ist. Hierzu durchsetzen sowohl der Bereich 9 der Siliziumschicht 6, als auch der unterhalb mit Abstand zu der Metallisierung 25 (Anschlussbereich) angeordnete Bereich 8 die obere Oxidschicht 12 und kontaktiert unmittelbar die Verdrahtungsebene 7 (vergleiche auch Fig. 10).

Die Metallisierung 25 wird zunächst als vollflächige Schicht auf der Verschlussschicht 24 aufgebracht und daraufhin strukturiert, sodass die in Fig. 10 gezeigten Metallisierungen 25 (Metallisierungsabschnitte) erhalten werden.

In einem abschließenden, nicht gezeigten Schritt können Kontaktbereiche zu den Metallisierungen 25, beispielsweise durch Kontaktdrähte hergestellt werden.

## Patentansprüche

1. Verfahren zum Verkappen eines MEMS-Wafers (1), insbesondere eines Sensor- und/oder Aktorwafers, mit mindestens einem beweglichen mechanischen Funktionselement (10),
wobei der MEMS-Wafer (1) mit dem beweglichen mechanischen Funktionselement (10) bereitgestellt wird,
wobei das bewegliche mechanische Funktionselement (10) mittels einer Opferschicht (14) fixiert wird,
wobei auf die Opferschicht (14) und/oder auf mindestens eine auf die Opferschicht (14) aufgebrachte Zwischenschicht (17) eine Kappenschicht (19) aufgebracht wird,
wobei die Kappenschicht (19) derart strukturiert wird, dass die Opferschicht (14) abschnittsweise freigelegt wird,
wobei die Opferschicht zumindest teilweise derart entfernt wird, dass das Funktionselement (10) wieder beweglich wird, und
wobei auf die Kappenschicht (19) eine Verschlussschicht (24) aufgebracht wird.

2. Verfahren nach Anspruch 1, **dadurch gekennzeichnet, dass** der MEMS-Wafer (1) vor dem Aufbringen der Opferschicht (14) sowie der Kappenschicht (19) metallisierungsfrei ist.

3. Verfahren nach einem der Ansprüche 1 oder 2, **dadurch gekennzeichnet, dass** das Funktionselement (10) vor dem Verkappungsprozess auf Funktionsfähigkeit geprüft wird.

4. Verfahren nach einem der vorhergehenden Ansprüche, **dadurch gekennzeichnet, dass** die Opferschicht (14) als Silizium-Germaniumschicht, insbesondere mittels eines LPCVD- oder PECVD-Verfahrens, aufgebracht wird.

5. Verfahren nach einem der vorhergehenden Ansprüche, **dadurch gekennzeichnet, dass** die Kappenschicht (19) aus mono- und/oder polykristallinem Silizium gebildet wird.

6. Verfahren nach einem der vorhergehenden Ansprüche, **dadurch gekennzeichnet, dass** die Zwischenschicht (17) als eine Diffusionsbarriere, vorzugsweise eine HTO-Schicht, ausgebildet wird.

7. Verfahren nach einem der vorhergehenden Ansprüche, **dadurch gekennzeichnet, dass** die Opferschicht (14) vor dem Aufbringen der Kappenschicht (19) strukturiert wird, insbesondere derart, dass mindestens ein später elektrisch zu kontaktierender Bereich (8, 9, 13) des MEMS-Wafers (1) freigelegt wird.

8. Verfahren nach einem der vorhergehenden Ansprüche, **dadurch gekennzeichnet, dass** die Kappenschicht (19), vorzugsweise mittels CMP, planarisiert wird,

9. Verfahren nach einem der vorhergehenden Ansprüche, **dadurch gekennzeichnet, dass** nach dem Entfernen der Opferschicht (14) eine Antihaftschicht (23), vorzugsweise mittels eines SIC- Abscheideprozesses, derart aufgebracht wird, dass das bewegliche Funktionselement (10) mit der Antihaftschicht (23) belegt wird.

10. Verfahren nach einem der vorhergehenden Ansprüche, **dadurch gekennzeichnet, dass** die Druckeinstellung in mindestens einer durch das Entfernen der Opferschicht (14) gebildeten Kavitäten (4, 22) durch den Systemdruck während des Verkappungsverfahrens oder durch Gasdiffusion durchgeführt wird.

11. Verfahren nach einem der vorhergehenden Ansprüche, **dadurch gekennzeichnet, dass** die Verschlussschicht (24) derart strukturiert wird, das die Kappenschicht (19) teilweise freigelegt wird und auf die strukturierte Verschlussschicht (24) und/oder auf die freigegebene Kappenschicht (19) mindestens eine Metallisierung (25) zur Kontaktierung des MEMS-Wafers (1) aufgebracht wird.

## Claims

1. Method for capping a MEMS wafer (1), in particular a sensor and/or actuator wafer, with at least one movable mechanical functional element (10),
wherein the MEMS water (1) with the movable mechanical functional element (10) is provided,
wherein the movable mechanical functional element (10) is fixed by means of a sacrificial layer (14),
wherein a cap layer (19) is applied to the sacrificial layer (14) and/or at least one intermediate layer (17) applied to the sacrificial layer (14),
wherein the cap layer (19) is structured in such a way that the sacrificial layer (14) is uncovered in sections,
wherein the sacrificial layer is removed at least partly in such a way that the functional element (10) is movable again, and
wherein a closure layer (24) is applied to the cap layer (19).

2. Method according to Claim 1, **characterized in that** the MEMS wafer (1) is metallization-free prior to the application of the sacrificial layer (14) and of the cap layer (19).

3. Method according to either of Claims 1 and 2, **characterized in that** the functional element (10) is tested for functionality prior to the capping process.

4. Method according to any of the preceding claims, **characterized in that** the sacrificial layer (14) is applied as a silicon-germanium layer, in particular by means of an LPCVD or PECVD method.

5. Method according to any of the preceding claims, **characterized in that** the cap layer (19) is formed from monocrystalline and/or polycrystalline silicon.

6. Method according to any of the preceding claims, **characterized in that** the intermediate layer (17) is formed as a diffusion barrier, preferably an HTO layer.

7. Method according to any of the preceding claims, **characterized in that** the sacrificial layer (14) is structured prior to the application of the cap layer (19), in particular in such a way that at least one region (8, 9, 13) of the MEMS wafer (1) with which electrical contact is to be made later is uncovered.

8. Method according to one of the preceding claims, **characterized in that** the cap layer (19) is planarized, preferably by means of CMP.

9. Method according to any of the preceding claims, **characterized in that**, after removal of the sacrificial layer (14), an antistiction layer (23) is applied, preferably by means of an SIC deposition process, in such a way that the functional element (10) is coated with the antistiction layer (23).

10. Method according to any of the preceding claims, **characterized in that** the pressure setting in at least one of cavities (4, 22) formed by the removal of the sacrificial layer (14) is implemented by the system pressure during the capping method or by gas diffusion.

11. Method according to any of the preceding claims, **characterized in that** the closure layer (24) is structured in such a way that the cap layer (19) is uncovered partly and at least one metallization (25) for making contact with the MEMS wafer (1) is applied to the structured closure layer (24) and/or to the freed cap layer (19).

## Revendications

1. Procédé d'encapsulation d'une galette MEMS (1), notamment une galette de capteur et/ou d'actionneur, comprenant au moins un élément fonctionnel (10) mécanique mobile,
la galette MEMS (1) étant fournie avec l'élément fonctionnel (10) mécanique mobile,
l'élément fonctionnel (10) mécanique mobile étant fixé par l'intermédiaire d'une couche sacrificielle (14), une couche d'encapsulation (19) étant appliquée sur la couche sacrificielle (14) et/ou sur au moins une couche intermédiaire (17) appliquée sur la couche sacrificielle (14),
la couche d'encapsulation (19) étant structurée de telle sorte que la couche sacrificielle (14) est libérée par portions,
la couche sacrificielle étant retirée au moins partiellement de telle sorte que l'élément fonctionnel (10) devient de nouveau mobile, et
une couche de fermeture (24) étant appliquée sur la couche d'encapsulation (19).

2. Procédé selon la revendication 1, **caractérisé en ce que** la galette MEMS (1) est exempte de métallisation avant l'application de la couche sacrificielle (14) et de la couche d'encapsulation (19).

3. Procédé selon l'une des revendications 1 ou 2, **caractérisé en ce que** l'élément fonctionnel (10) subit un contrôle d'aptitude au fonctionnement avant le processus d'encapsulation.

4. Procédé selon l'une des revendications précédentes, **caractérisé en ce que** la couche sacrificielle (14) est appliquée sous la forme d'une couche en silicium-germanium, notamment au moyen d'un procédé de LPCVD ou de PECVD.

5. Procédé selon l'une des revendications précédentes, **caractérisé en ce que** la couche d'encapsulation (19) est constituée de silicium mono-et/ou polycristallin.

6. Procédé selon l'une des revendications précédentes, **caractérisé en ce que** la couche intermédiaire (17) est réalisée sous la forme d'une barrière de diffusion, de préférence d'une couche HTO.

7. Procédé selon l'une des revendications précédentes, **caractérisé en ce que** la couche sacrificielle (14) est structurée avant l'application de la couche d'encapsulation (19), notamment de telle sorte qu'au moins une zone (8, 9, 13) de la galette MEMS (1) avec laquelle il faudra ultérieurement établir un contact électrique est libérée.

8. Procédé selon l'une des revendications précédentes, **caractérisé en ce que** la couche d'encapsulation (19) est planarisée, de préférence par CMP.

9. Procédé selon l'une des revendications précédentes, **caractérisé en ce qu'**après avoir enlevé la couche sacrificielle (14), une couche anti-adhérence (23) est appliquée, de préférence au moyen d'un procédé de précipitation SIC, de telle sorte que l'élément fonctionnel (10) mobile est revêtu de la couche anti-adhérence (23).

10. Procédé selon l'une des revendications précédentes, **caractérisé en ce que** le réglage de la pression dans au moins une cavité (4, 22) formée par l'enlèvement de la couche sacrificielle (14) est effectué par la pression du système pendant l'opération d'encapsulation ou par diffusion de gaz.

11. Procédé selon l'une des revendications précédentes, **caractérisé en ce que** la couche de fermeture (24) est structurée de telle sorte que la couche d'encapsulation (19) est partiellement libérée et au moins une métallisation (25) destinée à établir le contact avec la galette MEMS (1) est appliquée sur la couche de fermeture (24) structurée et/ou sur la couche d'encapsulation (19) libérée.
